# EUROPÄISCHE PATENTSCHRIFT

(11) **EP 1 523 585 B1**
(45) Veröffentlichungstag und Bekanntmachung des Hinweises auf die Patenterteilung: **20.05.2009**
(21) Anmeldenummer: 03764944.9
(22) Anmeldetag: 07.07.2003
(51) Int. Cl.: C23C 16/458, H01L 21/00

(54) **BE- UND ENTLADEVORRICHTUNG FÜR EINE BESCHICHTUNGSEINRICHTUNG**
LOADING AND UNLOADING DEVICE FOR A COATING UNIT
DISPOSITIF DE CHARGEMENT ET DE DECHARGEMENT POUR UN SYSTEME DE REVETEMENT

(30) Priorität: 19.07.2002 DE 10232731
(43) Veröffentlichungstag der Anmeldung: 20.04.2005
(73) Patentinhaber: Aixtron AG, 52072 Aachen (DE)
(72) Erfinder: JÜRGENSEN, Holger, 52072 Aachen (DE); KÄPPELER, Johannes, 52146 Würselen (DE); FRANKEN, Walter, 52249 Eschweiler (DE)
(74) Vertreter: Grundmann, Dirk
(86) Internationale Anmeldenummer: PCT/EP2003/007244
(87) Internationale Veröffentlichungsnummer: WO 2004/009299

(56) Entgegenhaltungen:
- WO-A-01/57908
- US-A- 5 383 971
- US-B1- 6 217 663
- US-B1- 6 413 459

## Beschreibung

Die Erfindung betrifft eine Vorrichtung zum Be- und Entladen einer Prozesskammer einer Beschichtungseinrichtung gemäß Gattungsbegriff des Anspruches 1.

Eine Vorrichtung der gattungsgemäßen Art ist aus der US 6,217,663 B1 bekannt. Die dort beschriebene Vorrichtung besitzt einen gabelförmigen Greifer, der eine ringförmige Ladeplatte untergreifen kann. Die Ladeplatte besitzt eine muldenartige Vertiefung zur Aufnahme des Substrates. Das Substrat liegt dabei auf radial einwärts ragenden Vorsprüngen. Mit dem gabelartigen Greifer kann die Ladeplatte in eine Prozesskammer oder eine Kassette eingebracht werden. Das Substrat wird dabei auf Vertikalstifte aufgesetzt.

Der Erfindung liegt die Aufgabe zugrunde, die gattungsgemäße Vorrichtung für einen CVD-Prozess weiterzuentwickeln.

Gelöst wird die Aufgabe durch die in den Ansprüchen angegebene Erfindung. Zunächst und im Wesentlichen wird darauf abgezielt, dass die Vorrichtung eine von einem Greifer greifbare Ladeplatte aufweist, welche für jedes zumindest eine Substrat eine von einem Rand einer jedem Substrat zugeordneten Öffnung gebildeten Lagerstelle ausbildet. Das Substrat liegt somit beim Beladen über der Öffnung. Der Öffnungsrand stützt den Rand des Substrates ab. In einer bevorzugten Ausgestaltung der Erfindung wird der Boden der Öffnung von einer Mulde ausgebildet. Das Substrat liegt somit in einer Mulde ein. Dies hat zur Folge, dass auf die Ladeplatte aufgebrachte Beschleunigungskräfte das Substrat nicht aus der Lagerstelle verlagern kann. Die jedem Substrat zugeordnete Öffnung kann kreisrund sein, so dass das Substrat lediglich mit seinem Rand auf dem Öffnungsrand aufliegt. Die Öffnung hat bevorzugt eine Kontur, die der Umrisskontur des Substrates ähnlich ist. Hat das Substrat eine im Wesentlichen kreisrunde Gestalt, so besitzt die Öffnung ebenfalls eine kreisrunde Gestalt allerdings mit einem geringeren Durchmesser. Hat das Substrat eine rechteckige oder polygonale Umrisskontur, so besitzt die Öffnung bevorzugt dieselbe, jedoch durchmesserkleinere Umrisskontur. Die Ladeplatte als solche kann eine Vielzahl von Lagerstellen aufweisen und eine im Wesentlichen kreisrunde Umfangskontur aufweisen. Auf der Rückseite weist die Ladeplatte einen Ringbund auf. Der Substrathalter weist ein oder mehrere sockelartige Substratträger auf, auf welchen die Ladeplatte aufsetztbar ist. Der Ringbund umschließt eine Aufnahmehöhlung zur Aufnahme des Substratträgers. Der Substratträger kann integraler Bestandteil des Substrathalters sein. Bevorzugt ist der Substratträger jedoch eine auf einem Gaslager drehantreibbare Platte. Die Ladeplatte kann auf diese Platte derart aufgestülpt werden, dass sie mit dem Substratträger mitdreht. Die Ladeplatte kann in einer Vertiefung des Substrathalters derart einliegen, dass ihre Oberfläche mit der Oberfläche des Substrathalters fluchtet. Das Material von Ladeplatte und Substrathalter kann gleich oder ähnlich sein. Der Ringbund weist eine konisch verlaufende Innenwandung auf. Der Substratträger, auf den die Ladeplatte aufgesetzt werden kann, bildet eine dazu formangepasste Umfangswandung aus. Beim Aufsetzen der Ladeplatte auf dem Substratträger erfolgt dann eine Selbstzentrierung der Ladeplatte. Die Außenwandung des Ringbundes kann eine Umfangsnut aufweisen. Diese Umfangsnut kann wiederum eine Eingriffsringnut ausbilden zum Eintritt eines Hakens des Greifers. Der Greifer kann bevorzugt zwei Greiferarme und einen Haken aufweisen. Die Länge der beiden Greifarme kann kürzer sein als der Durchmesser der Ladeplatte, so dass zufolge des außermittigen Angriffs der Greifarme in die Umfangsnut der Ladeplatte beim Anheben der Ladeplatte ein Kippmoment entsteht. Zufolge dieses Kippmomentes verkippt die Ladeplatte im Moment des Anhebens. Der in die Umfangsnut eingebrachte Haken tritt beim Verkippen der Ladeplatte in die Eingriffsnut der Peripherie der Ladeplatte, so dass diese sicher vom Greifer gehalten ist. Um mit dem Greifer und insbesondere mit den Armen und den Haken in Anlage an die Ladeplatte zu treten, besitzt der Substrathalter mindestens drei zum Rand hin offene Vertiefungen. Eine dieser Vertiefungen bildet eine Zentrieröffnung aus. Diese kann trapezförmige Öffnungswände besitzen. In diese Zentrieröffnung fährt ein Zentriervorsprung des Greifers ein, dem auch der Haken zugeordnet ist. Beim Einfahren des Zentriervorsprunges in die Zentrieröffnung kann der drehbare Substrathalter geringfügig gedreht werden, bis er seine optimale Ausrichtung erhalten hat. Dies ist für die positionsgenaue Ablage der Ladeplatte auf dem Substratträger förderlich. Zwei kanalartige, zum Rand des Substrathalters hin offene Aussparungen dienen dem Eingriff der Greifarme des Greifers beim Be- bzw. Entladen der Prozesskammer mit der Ladeplatte. Zur Vorrichtung kann ferner eine Entnahmeeinrichtung gehören. Diese Entnahmeeinrichtung besitzt zu jeder Öffnung der Ladeplatte zugeordnete Vertikalstützen. Über diese Vertikalstützen ist die Platte stülpbar. Dabei durchdringen die Vertikalstützen die Öffnungen der Ladeplatten und heben dabei die Substrate von der Ladeplatte ab. Die Substrate liegen dann auf den Vertikalstützen auf und können von den gleichen oder einem anderen Greifer erfasst werden, um eine Kassette oder einem anderen Zwischenlader zugeführt zu werden. Die Vertikalstützen können von mindestens drei Vertikalstiften ausgebildet werden.

Zufolge der zuvor beschriebenen Ausgestaltung ist ein automatisches Be- und Entladesystem für ein oder mehrere Substrate für eine Beschichtungseinrichtung gegeben. Dabei kann das Be- und/oder Entladen in sehr kurzer Zeit erfolgen. Der Vorgang kann bei Prozesstemperaturen (400°C bis 1200°C) stattfinden. Dadurch werden die Zeiträume zwischen den eigentlichen Beschichtungsvorgängen minimiert. Die Substrate werden aus Kassetten, welche eine Mehrzahl an Substraten aufnehmen können, entnommen und in den Reaktor transportiert. Nach erfolgter Beschichtung werden die Substrate wieder in den Kassetten abgelegt. Dabei werden die Substrate beim Be- und Entladen aus der Prozesskammer weder an ihrer Oberfläche noch an ihren Randkanten gegriffen oder geklammert. Insbesondere die Oberfläche des Substrates wird zu keiner Zeit berührt. Der komplette Vorgang kann automatisch ablaufen. Vorteilhaft ist ferner, dass beim Be- und Entladen keine Partikel generieren oder zur Substratoberfläche transportiert werden.

Zum Beladen der Prozesskammer mit einer Mehrzahl von Substraten werden diese außerhalb der Kammer zunächst automatisch in Mulden einer dünnen Ladeplatte eingelegt, die aus gleichen oder ähnlichem Material wie der Substrathalter in der Kammer besteht. Diese Ladeplatte ist so ausgebildet, dass die Substrate nur mit ihrer äußeren Peripherie in Aussparung in dieser Platte einliegen. Die Böden dieser Aussparungen bilden Öffnungen, die vom Durchmesser nur leicht geringer sind, als die Substratdurchmesser. Diese Ladeplatte kann mittelst der Entnahmeeinrichtung beladen werden. Hierzu wird die lösbare Ladeplatte zunächst über die Vertikalstützen gestülpt. Positionsgenau wird dann mittelst eines Roboterarmes auf die Vertikalstützen zumindest ein Substrat aufgelegt. Dann wird die Ladeplatte vertikal nach oben verlagert bis die Substrate auf dem Rand der Öffnungen aufliegen. Das Entladen erfolgt in umgekehrter Weise. Die Ladeplatte wird sodann von dem Greifer in die Prozesskammer eingebracht. Mittelst des zuvor beschriebenen Zentriervorsprungs wird der Substrathalter beim Einfahren des Zentriervorsprungs in die Zentrieröffnung des Substrathalters positioniert, so dass die Ladeplatte exakt über den Substratträger gestülpt werden kann. Der Substratträger kann heißer sein als die Ladeplatte. Durch Wärmeübertragung heizt sich die Ladeplatte dann aber auf die Temperatur des Substrathalters auf, wobei eine Längenausdehnung derart stattfindet, dass sich der Durchmesser der Ladeplatte geringfügig vergrößert. Zufolge der Konizität der Innenwandung des Ringbundes und der formangepassten Umfangswandung des Substratträgers rutscht die Ladeplatte im Zuge ihres Aufwärmens nach unten in ihre endgültige Position, in welcher die Substrate entweder flächig auf Abschnitten des Substratträgers aufliegen oder einen definierten Spaltabstand zur Oberfläche des Substrathalters besitzen. Der Spaltabstand wird von der Materialstärke der Ladeplatte definiert, die flächig auf der Oberfläche des Substratträgers aufliegt.

Zufolge des Zentriervorsprunges, der mit der Zentrieröffnung des Substrathalters zusammenwirkt, braucht der drehangetriebene Substrathalter zum Be- und Entladen nur grob vorpositioniert zu werden. Die Feinpositionierung erfolgt vom Greifer selbst Die Fesselung der Ladeplatte an den Greifer erfolgt beim Verkippen der Platte bei deren Anheben, wobei ein Haken in eine Eingriffsringnut der Ladeplatte eingreift. Die im Wesentlichen rotationssymmetrische Umfangskontur der Ladeplatte macht es möglich, dass diese unabhängig von ihrer Drehstellung vom Greifer greifbar ist.

Ausführungsbeispiele der Erfindung werden nachfolgend anhand beigefügter Zeichnungen erläutert. Es zeigen:

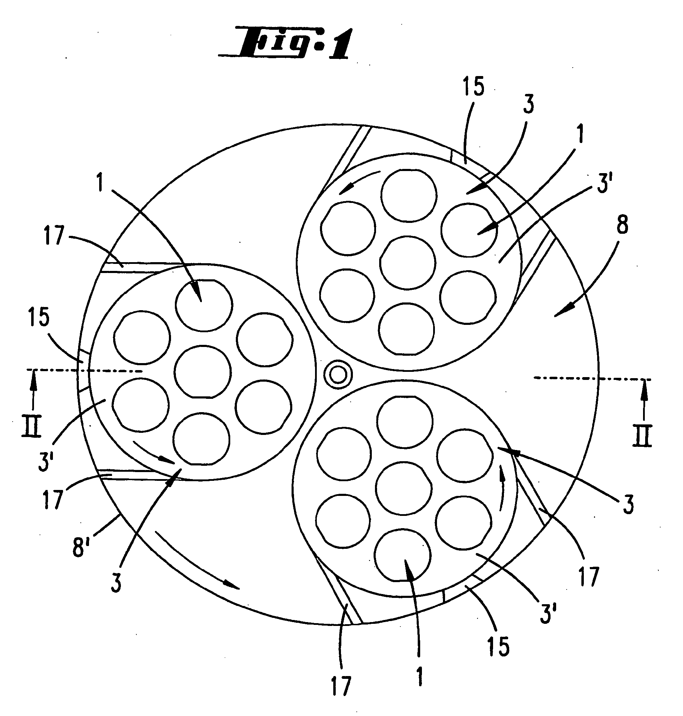

- Fig.1: in grob schematischer Darstellung einen Substrathalter mit insgesamt drei Substratträgern, auf welche jeweils eine Ladeplatte mit insgesamt sieben Lagerstellen gestülpt ist,
- Fig. 2: einen Schnitt gemäß der Linie II-II in Figur 1,
- Fig. 3: den in Figur 2 mit III bezeichneten Ausschnitt in vergrößerter Darstellung,
- Fig. 4: den in Figur 2 mit IV bezeichneten vergrößerten Ausschnitt in einer vergrößerten Darstellung,

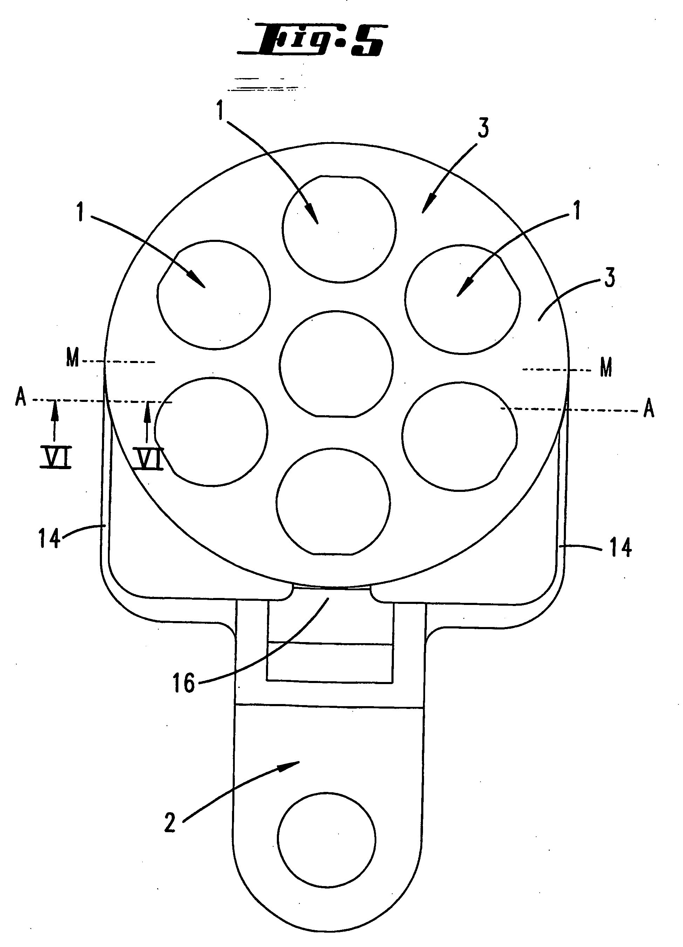

- Fig. 5: die Draufsicht auf eine von einem Greifer gehaltene Ladeplatte,
- Fig. 6: einen Schnitt gemäß der Linie VI-VI in Figur 5,
- Fig. 7: eine Darstellung gemäß Figur 3 mit vom Greifer angehobener Ladeplatte,

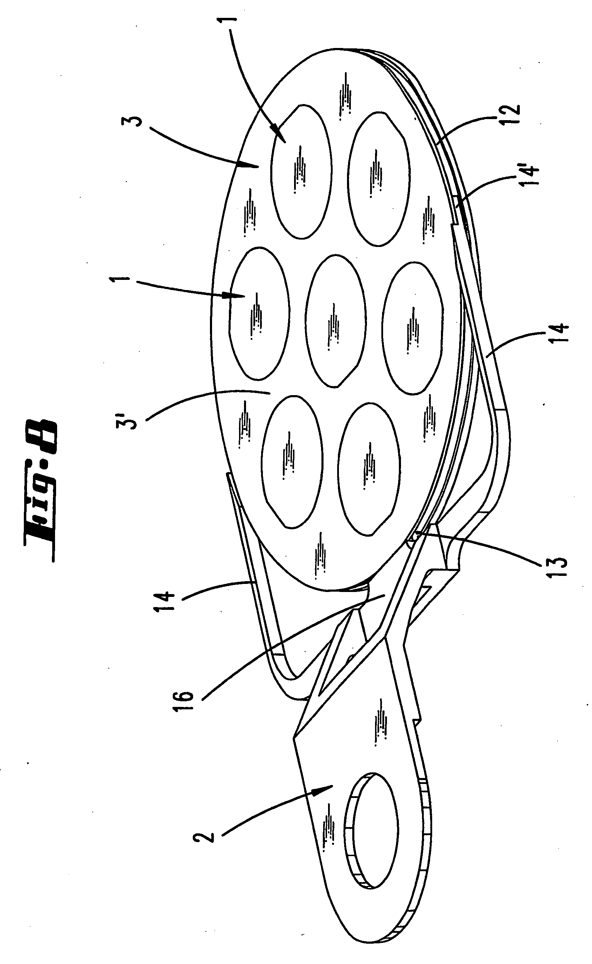

- Fig. 8: eine perspektivische Darstellung der von einem Greifer gehaltenen Ladeplatte,
- Fig. 9: eine Entnahmeeinrichtung mit über Vertikalstifte der Entnahmeeinrichtung gestülpter Ladeplatte,
- Fig. 10: ein zweites Ausführungsbeispiel der Erfindung in einer Darstellung gemäß Figur 3 und
- Fig. 11: das zweite Ausführungsbeispiel der Erfindung gemäß Figur 4.

Die erfindungsgemäße Vorrichtung findet Anwendung in einem CVD-Reaktor. Ein solcher Reaktor besitzt eine Prozesskammer, in der eine bestimmte Gasphasenzusammensetzung eingestellt wird, damit auf Substraten, die auf einem Substrathalter aufliegen, der den Boden der Prozesskammer bildet, eine oder mehrere Schichten abgeschieden werden, wobei das Schichtmaterial über die Gase der Gasphase zugeführt wird. Bei dem Prozess kann es sich um einen VPE, MOCVD oder ganz allgemein um einen CVD-Prozess handeln.

Die erfindungsgemäße Vorrichtung ist ein Hilfsmittel zum Be- und Entladen der Prozesskammer mit Substraten in Form einer Ladeplatte 3, die bestückt mit Substraten 1 vor dem Prozess in die Prozesskammer eingebracht wird und während des Beschichtungsprozesses dort verbleibt, um nach Beendigung des Beschichtungsprozesses zusammen mit den Substraten wieder aus der Prozesskammer entnommen zu werden.

Die in den figürlich dargestellten Ausführungsbeispielen gezeigte Ladeplatte 3 hat eine kreisrunde Gestalt. In gleichmäßiger Anordnung befindet sich auf der Oberfläche der Ladeplatte 3 eine Anzahl von Öffnungen 5. Die Öffnungen 5 befinden sich jeweils in Mulden, so dass sie einen vertieft liegenden Rand 4 ausbilden, auf dem der Rand 1' je eines Substrates 1 aufliegen kann. Die Mulden bilden jeweils eine Lagerstelle 6 für ein Substrat 1 aus. Dabei ist die Umfangskontur der Mulde der Umfangskontur des Substrates im Wesentlichen angepasst. Im Ausführungsbeispiel ist die Umfangskontur einer jeden Lagerstelle 6 genau der Umfangskontur des Substrates 1 angepasst. Die Mulde bildet somit, wie auch das Substrat, einen unrunden Abschnitt. Es ist aber auch vorgesehen, dass die Mulde eine kreisrunde Umfangskontur besitzt. Ebenso besitzt dann auch die Öffnung 5, die den Boden der Mulde bildet, eine kreisrunde Umfangskontur, wobei der Durchmesser der Öffnung 5 geringer ist als der Durchmesser des Substrates, um die Randauflage auf dem Rand 4 zu sichern.

Auf der Rückseite der im inneren Bereich dünn, 1 bis 3 mm dick ausgeführten Ladeplatte 3 befindet sich nahe dem Rand 3" der Ladeplatte 3 ein Ringbund 9. Auf seiner nach außen weisenden Seite bildet der Ringbund 9 eine Umfangsringnut 18 aus, welche zudem eine hinterschnittene Eingriffsringnut 12 bildet. Mit seiner nach innen weisenden Seite bildet der Ringbund 9 mit einer konisch verlaufenden Flanke die Umrandung einer Aufnahmehöhlung. Diese konische Flanke 9' kann in Flächenanlage gebracht werden mit einer dazu passenden Schrägflanke eines Substratträgers 8.

Im Ausführungsbeispiel bildet der Substratträger 8 eine sockelartige Erhöhung und schwebt während des Prozesses auf einem Gaslager, welches den Substratträger 8 zudem drehantreibt, so dass die über dem Substratträger 8 gestülpte Ladeplatte 3 mitdreht. In einem nicht dargestellten Ausführungsbeispiel kann der Substratträger 8 aber auch integraler Bestandteil des Substrathalters 7 sein.

Der Substratträger 8 liegt in einer Vertiefung 11 des Substrathalters 7 ein. Er ist umgeben von einer Umfangsnut, in welche der Ringbund 9 der Ladeplatte 3 derart eintauchen kann, dass die Oberfläche 3' mit der Oberfläche 7' des Substrathalters 7 fluchtet. Es ist aber auch möglich, dass die Oberfläche 3' gegebenenfalls aus strömungstechnischen Gründen gegenüber der Oberfläche 7' erhaben ist.

Die Durchmesser von Substratträger 8 und Ringbund 9 sind derartig aufeinander abgestimmt, dass die Unterseite der Ladeplatte 3 bei Prozesstemperatur auf der Oberseite des Substratträgers 8 aufliegt.

Wird eine kalte Ladeplatte auf einen heißen Substratträger 8 aufgebracht, so dehnt sich die Ladeplatte 3 thermisch aus und rutscht dann in ihre endgültige Position herab.

Das Material der Ladeplatte 3 entspricht dem Material des Substrathalters 7 bzw. des Substratträgers 8.

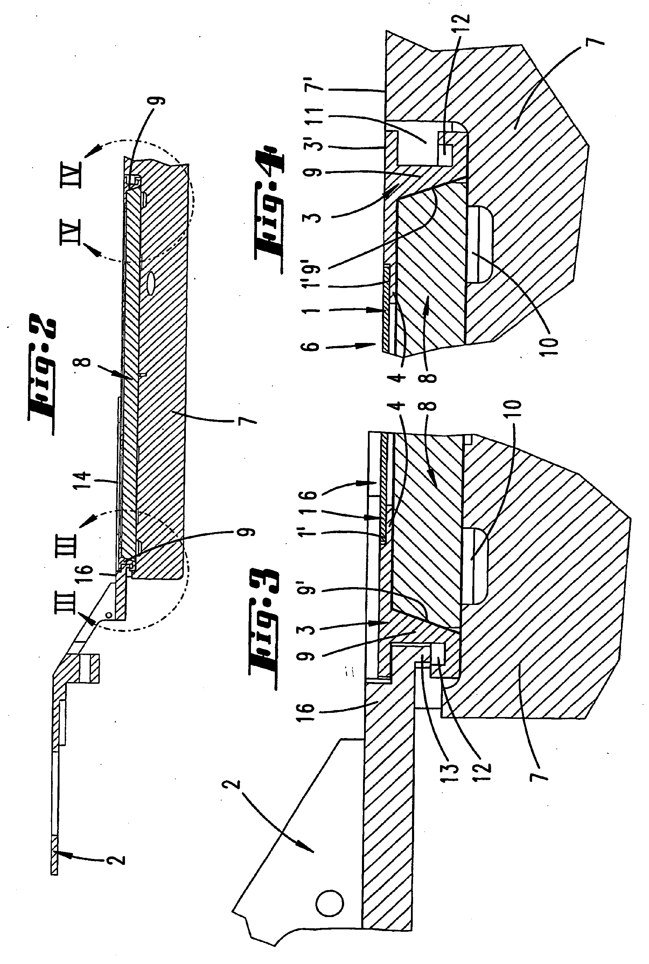

Bei dem in den Figuren 3 und 4 dargestellten Ausführungsbeispiel liegt das Substrat 1 mit einem Spaltabstand über der Oberfläche des Substratträgers 8, so dass das Substrat 1 durch Wärmestrahlung aufgeheizt wird.

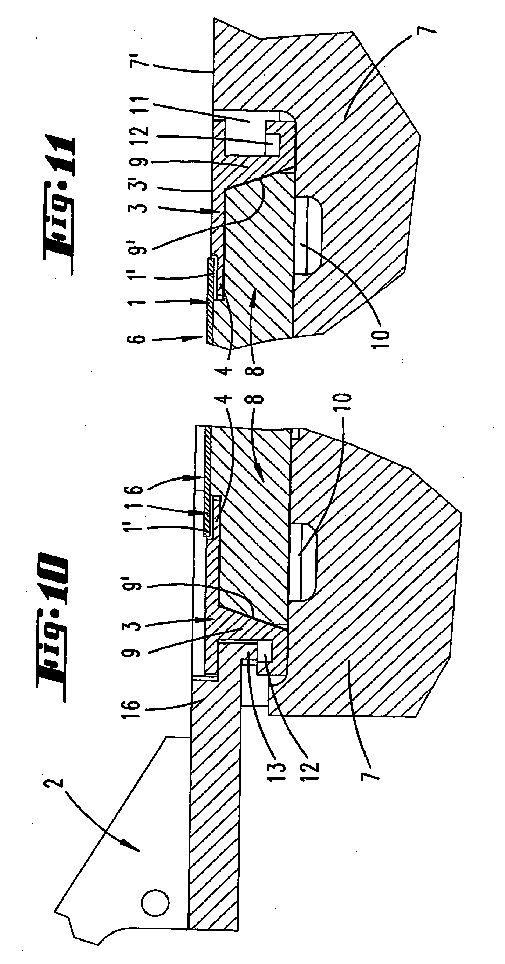

Bei dem in den Figuren 10 und 11 dargestellten Ausführungsbeispiel besitzt der Substratträger 8 eine zentrale Erhöhung, auf der das Substrat 1 flächig aufliegt. Beim Aufsetzen der Ladeplatte 3 auf den Substratträger 8 wird das Substrat 1 geringfügig über den Rand 4 der Lagerstelle 6 angehoben. Es kann aber von dem Rand der Mulde noch randgefasst sein.

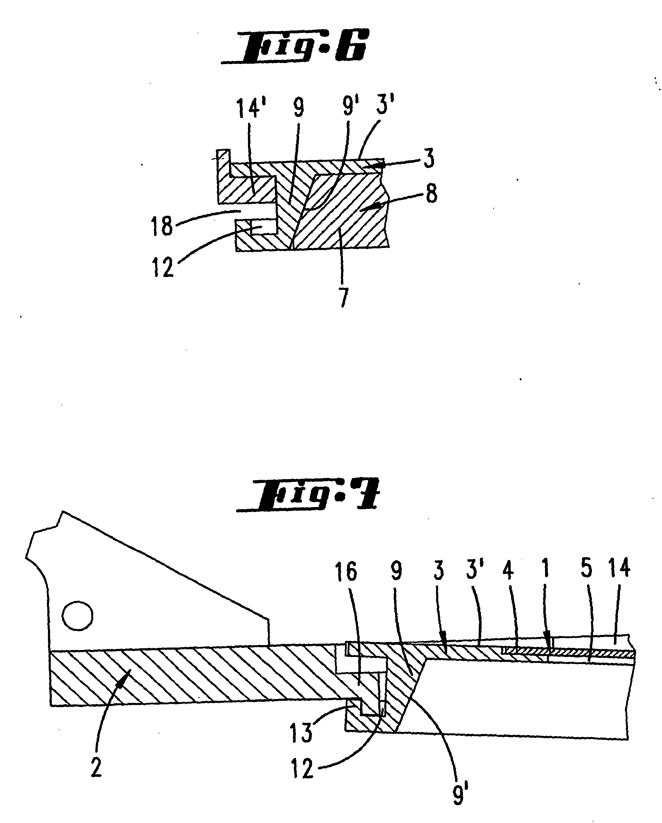

Das Be- und Entladen erfolgt mit einem Greifer 2. Dieser Greifer besitzt zwei gabelartige Greifarme 14, die mit Greifabschnitten 14' in die besagte Umfangsringnut 18 eingreifen können (vgl. Figur 6). Somit kann der äußere Rand 3" der Ladeplatte 3 von dem Greifarm 14 untergriffen werden, um die Ladeplatte 3 aus ihrer Position in der Vertiefung 11 des Substrathalters 7 herauszuheben. Hierzu ragen die Greifarme 14 in randoffene Kanäle 17 des Substrathalters 7 ein. Zwischen den beiden Kanälen 17 befindet sich eine Zentrieröffnung 15. Die Zentrieröffnung 15 hat einen trapezförmigen Grundriss mit schrägen Wänden. In diese zentrieroffene Öffnung 15 taucht bei der Zuführung des Greifers 2 ein Zentriervorsprung 16 ein. An diesem Zentriervorsprung 16 ist ein Haken 13 angeformt. Dieser Haken 13 tritt in die Umfangsringnut 18 ein.

Um den Substrathalter 7 in die richtige Drehorientierung zu bringen, besitzt er auf seiner Umfangsfläche Rippen/Nuten, die optisch abgetastet werden können. Die Zentrierung ist somit nicht nur mechanisch, sondern auch optisch möglich.

Die Länge der Greifarme 14 ist geringer als der Durchmesser der Ladeplatte 3. Die sich durch Angriff der Greifabschnitte 14' an der Ladeplatte 3 definierende Achse A liegt somit außermittig der Diagonalen M, so dass beim Anheben der Ladeplatte 3 ein Kippmoment auftritt. Die Verkippung der Ladeplatte 3 führt zum Eingriff des Hakens 3 in die Eingriffsringnut 12. Zufolge dieses Eingriffs kann die Ladeplatte 3 nicht aus dem Greifer 2 herausrutschen, wenn der Greifer translatorische Bewegungen vollführt.

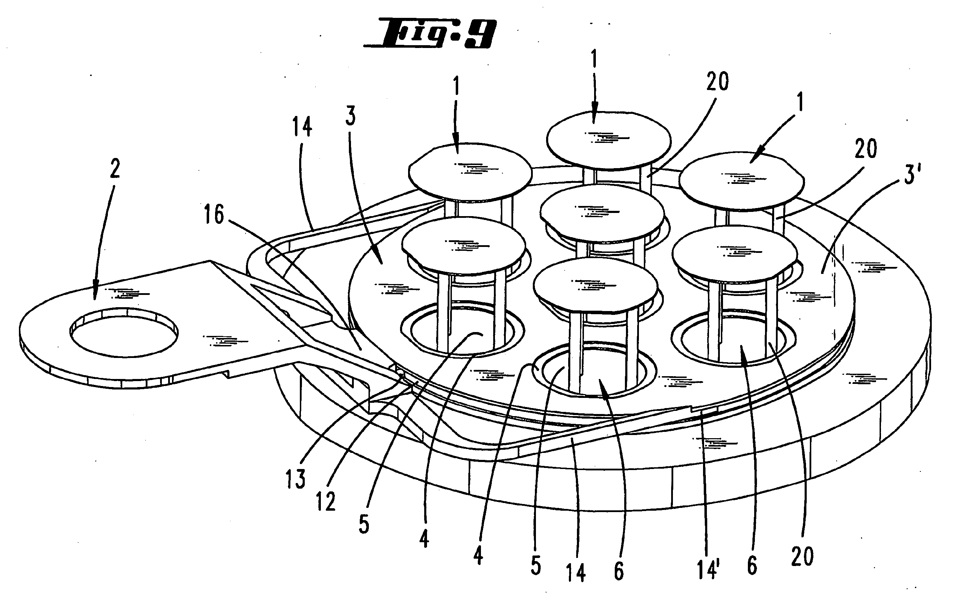

Das Aufnehmen bzw. Ablegen der Substrate 1 erfolgt unter Zufhilfenahme einer außerhalb der Prozesskammer angedeuteten Entnahmeeinrichtung 19. Bei dieser Entnahmeeinrichtung 19 handelt es sich im Wesentlichen um eine in der Horinzontalebene angeordnete Platte, aus welcher eine Vielzahl von Vertikalstützen abragen. Jede Vertikalstütze besteht aus insgesamt drei Vertikalstiften 20. Diese drei Vertikalstifte 20 durchragen jeweils eine eine Lagerstelle 6 definierende Öffnung 5. Wird die Ladeplatte 3 in dieser Art über die Vertikalstifte 20 gestülpt, so werden die Substrate aus ihren Lagerstellen 6 abgehoben und können in der in Figur 9 dargestellten Stellung von anderen Greifern gegriffen werden, um Kassetten oder dergleichen zugeführt zu werden. Die Beladung der Ladeplatte 3 mit Substraten erfolgt in umgekehrter Reihenfolge. Mittels nicht dargestellter Greifer werden die Substrate auf die Vertikalstifte 20 derart gelegt, dass sie fluchtend oberhalb der Lagerstellen 6 liegen. Wird jetzt der Greifer 2 in Vertikalrichtung gehoben, so lagern sich die Substrate 1 in den Lagerstellen 6 ein.

Bei einem nicht dargestellten Ausführungsbeispiel besitzt der Substrathalter nur einen Substratträger 8, der die Form eines Sockels besitzt. Dieser Substratträger 8 kann materialeinheitlich mit dem Substrathalter 7 verbunden sein. Auch bei dieser Ausgestaltung ist es vorgesehen, dass der Substrathalter 8 als Ganzes drehangetrieben ist.

In einem weiteren, nicht dargestellten Ausführungsbeispiel der Erfindung ist vorgesehen, dass die Ladeplatte 3 nur eine einzige Öffnung 5 aufweist für ein einziges Substrat.

Zum Drehantrieb des Substratträgers kann auch ein rein mechanischer Antrieb Verwendung finden. Beispielsweise kann der Substrathalter ein Planetengetriebe beinhalten mit einem eine Innenverzahnung aufweisenden, sich randnah erstreckenden Zahnkranz und einem drehantreibbaren zentralen außenverzahnten Sonnenrad, wobei beide Verzahnungen mit Planetenrädern kämmen und jedem Planetenrad ein Substratträger zugeordnet ist.

Die erfindungsgemäße Vorrichtung ist für die Herstellung aller Compound-Halbleiter geeignet, insbesondere für Verfahren zur Herstellung Silizium-Halbleiter für high-k, Ferroelectrica und andere Silicium-Prozesse. Insbesondere eignet sich die Vorrichtung für die Herstellung von Displays. Die Vorrichtung kann zusammen mit ein oder mehreren Robotoren zum Beladen und Entladen eines Reaktors verwendet werden. Es können sowohl rechteckige, als auch runde Substrate verwendet werden. Die Vorrichtung kann mit verschiedenen Handhabungsautomaten und deren Greifern verwendet werden. Auch kann als Material für die Ladeplatte ein Metall, Siliziumoxyd, Graphit, Molybdän oder ein anderes brauchbares Material verwendet werden. Die Vorrichtung kann bei hohen (über 1000°) und bei niedrigen Temperaturen (unter 600°) sowie hohen und auch niedrigen Prozesskammerdrücken (0,1 bis 1000 Pa (mbar)) betrieben werden. Die Vorrichtung zeichnet sich durch die Ermöglichung von sehr kurzen Ladezeiten aus. Beispielsweise braucht beim Beladen die Prozesskammer nicht vollständig abgekühlt zu werden. Das Andocken des Handhabungsautomaten an den Substrathalter kann mechanisch oder optisch gesteuert sein. Der Roboter kann mit mehreren Prozesskammern zusammenwirken. Beispielsweise kann die Ladeplatte einer Prozesskammer entnommen werden und einer anderen Prozesskammer zugeführt werden. Vorgesehen ist auch, dass eine leere Ladeplatte in einer besonderen Vorrichtung gereinigt werden kann. Die Reinigung der Ladeplatte kann aber auch in einer Prozesskammer erfolgen. Das Reinigen kann beispielsweise durch Ätzen erfolgen. Die Substrate können zusammen mit der Ladeplatte von einer Prozesskammer in andere Prozesskammern oder in Zwischenlage transportiert werden. Die Vorrichtung kann auch im Zusammenhang mit Kontrollvorrichtungen wie FTIR oder Ellipsometrie verwendet werden.

Die Vorrichtung ist ganz allgemein für jeden CVD-Prozess und auch für jeden Kondensationsbeschichtungsprozess geeignet. Sie kann verwendet werden für die Abscheidung von Metallen, Isolatoren, Halbleiterschichten aus den Elementen der Gruppe IV, III-IV, II-VI sowie von organischen Stoffen. Als Substratmaterial kommt jede Art von Festkörper in Frage. Insbesondere Silicium, III-V-Halbleiter, II-VI-Halbleiter oder Isolatoren wie Glas. Als Substrat kann insbesondere für die Display-Fertigung Kunststoff verwendet werden. Gerade für die Fertigung von Displays wird ein Kondensationsverfahren verwendet.

## Patentansprüche

1. Vorrichtung zum Be- und Entladen einer Prozesskammer einer Beschichtungseinrichtung mit zumindest einem Substrat (1) mittels eines Greifers (2) eines Handhabungsautomaten, wobei die Vorrichtung eine von dem Greifer (2) greifbare Ladeplatte (3) aufweist, welche für jedes mindestens eine Substrat (1) eine von einem Rand (4) einer jedem Substrat (1) zugeordneten Öffnung (5) gebildeten Lagerstelle ausbildet, **gekennzeichnet durch** eine von einem der Rückseite der Ladeplatte (3) angeformten, eine konisch verlaufende Innenwandung (9') aufweisenden Ringbund (9) umschlossenen Aufnahmehöhlung zur Aufnahme eines daran angepassten sockelartigen Substratträgers (8) mit einer zur Innenwandung (9') formangepassten Umfangswandung, auf welchen Substratträger (8) die Ladeplatte aufsetzbar ist.

2. Vorrichtung nach Anspruch 1, **dadurch gekennzeichnet, dass** die Öffnung (5) dem Boden einer Mulde zugeordnet ist.

3. Vorrichtung nach einem der vorhergehenden Ansprüche, **dadurch gekennzeichnet, dass** die jedem Substrat (1) zugeordnete Öffnung im Wesentlichen kreisrund ist, so dass das Substrat (1) lediglich mit seinem Rand auf dem Öffnungsrand aufliegt.

4. Vorrichtung nach einem der vorhergehenden Ansprüche, **dadurch gekennzeichnet, dass** die im Wesentlichen kreisrunde Ladeplatte (3) eine Vielzahl von Lagerstellen (6) aufweist.

5. Vorrichtung nach einem der vorhergehenden Ansprüche, **dadurch gekennzeichnet, dass** die Ladeplatte (3) derart auf den Substratträger (8) aufsetzbar ist, dass Oberflächenabschnitte des Substratträgers (8) einen Spaltabstand zum Substrat (1) haben oder dass das Substrat (1) auf einem Oberflächenabschnitt flächig aufliegt.

6. Vorrichtung nach einem der vorhergehenden Ansprüche, **dadurch gekennzeichnet, dass** der Substratträger (8) auf einem Gaslager (10) aufliegend oder mechanisch beispielsweise mittelst eines Planetengetriebes drehantreibbar ist.

7. Vorrichtung nach einem der vorhergehenden Ansprüche, **dadurch gekennzeichnet, dass** die Ladeplatte (3) in einer Vertiefung des Substrathalters (7) derart einliegt, dass ihre Oberfläche (3') mit der Oberfläche (7') des Substrathalters (7) fluchtet.

8. Vorrichtung nach einem der vorhergehenden Ansprüche 1 bis 6, **dadurch gekennzeichnet, dass** die Ladeplatte (3) in einer Vertiefung des Substrathalters (7) derart einliegt, dass ihre Oberfläche (3') gegenüber der Oberfläche (7') des Substrathalters (7) erhaben ist.

9. Vorrichtung nach einem der vorhergehenden Ansprüche, **dadurch gekennzeichnet, dass** das Material von Ladeplatte (3) und Substrathalter im Wesentlichen identisch ist.

10. Vorrichtung nach einem der vorhergehenden Ansprüche, **gekennzeichnet durch** eine von der Außenwandung des Ringbundes gebildete Eingriffsnut (12) zum Eingriff eines Hakens (13) des Greifers (2), wobei die Länge der Greifarme (14) kürzer ist als der Durchmesser der Ladeplatte (3), so dass zufolge des außermittigen Angriffs der Greifarme (14) in eine Umfangsnut der Ladeplatte ein beim Anheben der Ladeplatte (3) entstehendes Kippmoment den Haken (13) in die Eingriffsmut (12) eintreten lässt.

11. Vorrichtung nach Anspruch 10, **gekennzeichnet durch** eine dem Rand des Substrathalters (8) zugeordnete Zentrieröffnung (15) zum Eintritt eines den Haken (13) tragenden Zentriervorsprungs (16) des Greifers (2) und / oder eine optische Vorrichtung zur Zentrierung des Substrathalters (7).

12. Vorrichtung nach einem der vorhergehenden Ansprüche, **gekennzeichnet durch** zum Rand (8') des Substrathalters hin offene Kanäle (17) zum Eintritt der Greifarme (14) des Greifers (2).

13. Vorrichtung nach einem der vorhergehenden Ansprüche, **gekennzeichnet durch** eine mit der Ladeplatte (3) zusammenwirkende Entnahmeeinrichtung (19), mit jeder Öffnung (5) zugeordneten Vertikalstützen (20), über welche die Ladeplatte (3) stülpbar ist, um die Substrate (1) von der Ladeplatte (3) zu entfernen.

14. Vorrichtung nach Anspruch 13, **dadurch gekennzeichnet, dass** die Vertikalstützen von jeweils mindestens drei Vertikalstiften (20) gebildet sind.

15. Vorrichtung nach einem der vorhergehenden Ansprüche, **dadurch gekennzeichnet, dass** der Vorrichtung ein oder mehrere Robotoren zugeordnet sind.

16. Vorrichtung nach einem der vorhergehenden Ansprüche, **dadurch gekennzeichnet, dass** der Vorrichtung mehrere Prozesskammern zugeordnet sind, wobei die Substrate auf einer Ladeplatte (3) aufliegend von einer Prozesskammer in die andere Prozesskammer verbracht werden kann.

17. Vorrichtung nach einem der vorhergehenden Ansprüche, **dadurch gekennzeichnet, dass** die Vorrichtung Analyse-Einrichtungen wie FTIR oder Ellipsometrie aufweist.

18. Vorrichtung nach einem der vorhergehenden Ansprüche, **gekennzeichnet durch** eine oder mehrere Abkühl- und / oder Aufheizstationen.

19. Vorrichtung nach einem der vorhergehenden Ansprüche, **gekennzeichnet durch** eine Orientierungsstation zur Orientierung der Ladeplatte (3).

20. Vorrichtung nach einem der vorhergehenden Ansprüche, **dadurch gekennzeichnet, dass** der Substrathalter (7) Rotationsmonitor-Nuten aufweist, um dessen Drehzahl und Drehstellung zu ermitteln.

21. Verwendung einer Vorrichtung nach einem der vorhergehenden Ansprüche bei einem Fertigungsprozess für die Abscheidung von Halbleiterschichten auf Halbleitersubstraten.

22. Verwendung einer Vorrichtung nach einem der vorhergehenden Ansprüche, **dadurch gekennzeichnet, dass** die Vorrichtung zur Herstellung eines Displays verwendet wird.

23. Verwendung einer Vorrichtung nach einem der vorhergehenden Ansprüche, **dadurch gekennzeichnet, dass** die Vorrichtung ganz allgemein für einen CVD-Prozess oder auch einen Kondensationsbeschichtungsprozess verwendet wird und insbesondere für die Abscheidung von Halbleiterschichten aus Elementen der Gruppe IV, III-V, II-VI, Metallen, Isolatoren, insbesondere Dielectrica sowie organischen Stoffen auf Silizium-Substraten, III-V-Substraten, II-VI-Substraten oder Isolatoren wie Glas oder Kunststoff.

24. Verwendung einer Vorrichtung nach einem der vorhergehenden Ansprüche, **dadurch gekennzeichnet, dass** die Vorrichtung mit Wasserstoff und / oder Stickstoff betrieben wird.

25. Verwendung einer Vorrichtung nach einem der vorhergehenden Ansprüche, **gekennzeichnet durch** eine integrate, automatische Reinigungsprozedur für die Ladeplatte (3) in der Vorrichtung.

## Claims

1. Apparatus for loading and unloading a process chamber of a coating device comprising at least one substrate (1) by means of a gripper (2) of an automated handling unit, the apparatus comprising a loading plate (3) which can be gripped by the gripper (2) and forms, for each at least one substrate (1) a bearing which is formed by an edge (4) of an opening (5) associated with each substrate (1), **characterised by** a receiving recess, which is integrally formed on the rear of the loading plate, and surrounded by an annular collar (9) comprising a conically extending inner wall (9') and (3) is intended to receive a base-like substrate carrier (8), which is adapted to said receiving recess and which comprises a circumferential wall, adapted to match the shape of the inner wall (9') and on which substrate carrier (8) the loading plate can be placed.

2. Apparatus according to claim 1, **characterised in that** the opening (5) is associated with the base of a cavity.

3. Apparatus according to any one of the preceding claims, **characterised in that** the opening associated with each substrate (1) is substantially circular in such a way that only the edge of the substrate (1) rests on the edge of the opening.

4. Apparatus according to any one of the preceding claims, **characterised in that** the substantially circular loading plate (3) comprises a plurality of bearings (6).

5. Apparatus according to any one of the preceding claims, **characterised in that** the loading plate (3) can be placed on the substrate carrier (8) in such a way that surface portions of the substrate carrier (8) are spaced from the substrate (1) by a gap, or **in that** the substrate (1) rests on a surface portion in a planar manner.

6. Apparatus according to any one of the preceding claims, **characterised in that** the substrate carrier (8) can be rotatably driven by resting on a gas bearing (10) or can be driven mechanically by a planetary gear.

7. Apparatus according to any one of the preceding claims, **characterised in that** the loading plate (3) rests in a depression in the substrate holder (7) in such a way that the surface (3') thereof is level with the surface (7') of the substrate holder (7).

8. Apparatus according to any one of claims 1 to 6, **characterised in that** the loading plate (3) rests in a depression in the substrate holder (7) in such a way that the surface (3') thereof is raised in relation to the surface (7') of the substrate holder (7).

9. Apparatus according to any one of the preceding claims, **characterised in that** the material of the loading plate (3) and substrate holder is substantially identical.

10. Apparatus according to any one of the preceding claims, **characterised by** an engagement groove (12), formed by the outer wall of the annular collar, for engaging a hook (13) of the gripper (2), the length of the gripper arms (14) being shorter than the diameter of the loading plate (3) in such a way that, on account of the eccentric engagement of the gripper arms (14) in a circumferential groove in the loading plate (3), a tilting moment produced by raising the loading plate (3) enables the hook (13) to enter into the engagement groove (12).

11. Apparatus according to claim 10, **characterised by** a centring opening (15), which is associated with the edge of the substrate holder (8) and allows a centring projection (16), supporting the hook (13), of the gripper (2) to enter therein and/or an optical device for centring the substrate holder (7).

12. Apparatus according to any one of the preceding claims, **characterised by** channels (17) which are open towards the edge (8') of the substrate holder and allow the gripper arms (14) of the gripper (2) to enter therein.

13. Apparatus according to any one of the preceding claims, **characterised by** a removal device (19), which cooperates with the loading plate (3) and comprises vertical supports (20) which are associated with each opening (5) and over which the loading plate (3) can be fitted in order to remove the substrate (1) from the loading plate (3).

14. Apparatus according to claim 13, **characterised in that** the vertical supports are each formed by at least three vertical pins (20).

15. Apparatus according to any one of the preceding claims, **characterised in that** one or more robots are associated with the apparatus.

16. Apparatus according to any one of the preceding claims, **characterised in that** a plurality of process chambers are associated with the apparatus, it being possible for the substrates resting on a loading plate (3) to be moved from one process chamber into another process chamber.

17. Apparatus according to any one of the preceding claims, **characterised in that** the apparatus comprises analysis devices such as FTIR or ellipsometry devices.

18. Apparatus according to any one of the preceding claims, **characterised by** one or more cooling and/or heating stations.

19. Apparatus according to any one of the preceding claims, **characterised by** an orientation station for orienting the loading plate (3).

20. Apparatus according to any one of the preceding claims, **characterised in that** the substrate holder (7) comprises rotation monitoring grooves for determining the rotational speed and a rotational position thereof.

21. Use of an apparatus according to any one of the preceding claims in a manufacturing process for depositing semiconductor layers on semiconductor substrates.

22. Use of an apparatus according to any one of the preceding claims, **characterised in that** the apparatus is used for producing a display.

23. Use of an apparatus according to any one of the preceding claims, **characterised in that** the apparatus is used very generally in a CVD process or a condensation coating process and is used in particular to deposit semiconductor layers made of elements of the groups IV, III-V, II-VI, metals, insulators, in particular dielectrics, and organic substances on silicon substrates, III-V substrates, II-VI substrates or insulators such as glass or plastics material.

24. Use of an apparatus according to any one of the preceding claims, **characterised in that** the apparatus operates using hydrogen and/or nitrogen.

25. Use of a device according to any one of the preceding claims, **characterised by** an integral, automatic procedure for cleaning the loading plate (3) in the apparatus.

## Revendications

1. Dispositif de chargement et de déchargement d'une chambre de réaction d'un appareil de revêtement avec au moins un substrat (1), au moyen d'une pince (2) d'un automate de manipulation, le dispositif comportant une plaque de chargement (3) qui peut être saisie par la pince (2) et qui forme, pour chaque substrat, un emplacement de support constitué par un bord (4) d'une ouverture (5) associée à chaque substrat (1), **caractérisé par** une cavité de réception entourée par un rebord annulaire (9), qui est formé au dos de la plaque de chargement (3) et qui comporte une paroi intérieure (9') conique, et destinée à recevoir un porte-substrat (8), de type socle, qui est adapté à la cavité de réception et a une paroi périphérique dont la forme est adaptée à celle de la paroi intérieure (9'), la plaque de chargement pouvant être placée sur le porte-substrat (8).

2. Dispositif selon la revendication 1, **caractérisé en ce que** l'ouverture (5) est associée au fond d'une cuvette.

3. Dispositif selon l'une des revendications précédentes, **caractérisé en ce que** l'ouverture associée à chaque substrat (1) est sensiblement circulaire, de manière à ce que le substrat (1) repose simplement, par son bord, sur le bord de l'ouverture.

4. Dispositif selon l'une des revendications précédentes, **caractérisé en ce que** la plaque de chargement (3), sensiblement circulaire, comporte une pluralité d'emplacements de support (6).

5. Dispositif selon l'une des revendications précédentes, **caractérisé en ce que** la plaque de chargement (3) peut être placée sur le porte-substrat (8) de manière à ce que des portions de surface du porte-substrat (8) se trouvent à distance du substrat (1), en ménageant une fente, ou à ce que le substrat (1) repose à plat sur une portion de surface.

6. Dispositif selon l'une des revendications précédentes, **caractérisé en ce que** le porte-substrat (8) peut être entraîné en rotation en suspension sur un coussin de gaz (10) ou mécaniquement, par exemple au moyen d'un engrenage planétaire.

7. Dispositif selon l'une des revendications précédentes, **caractérisé en ce que** la plaque de chargement (3) est logée dans un évidement du porte-substrat (7) de manière à ce que sa surface (3') soit alignée avec la surface (7') du porte-substrat (7).

8. Dispositif selon l'une des revendications précédentes 1 à 6, **caractérisé en ce que** la plaque de chargement (3) est logée dans un évidement du porte-substrat (7) de manière à ce que sa surface (3') soit en saillie par rapport à la surface (7') du porte-substrat (7).

9. Dispositif selon l'une des revendications précédentes, **caractérisé en ce que** le matériau de la plaque de chargement (3) et celui du porte-substrat sont sensiblement identiques.

10. Dispositif selon l'une des revendications précédentes, **caractérisé par** une gorge d'engagement (12), formée par la paroi extérieure du bord annulaire et destinée à l'engagement d'un crochet (13) de la pince (2), la longueur des bras de préhension (14) étant inférieure au diamètre de la plaque de chargement (3) de sorte que, les bras de préhension (14) s'engageant de façon excentrée dans une gorge périphérique de la plaque de chargement, un couple de renversement généré lors du soulèvement de la plaque de chargement (3) permet de faire entrer le crochet (13) dans la gorge d'engagement (12).

11. Dispositif selon la revendication 10, **caractérisé par** une ouverture de centrage (15), associée au bord du porte-substrat (8) et destinée à faire entrer une saillie de centrage (16) de la pince (2), supportant le crochet (13), et/ou par un dispositif optique permettant de centrer le porte-substrat (7).

12. Dispositif selon l'une des revendications précédentes, **caractérisé par** des canaux (17) qui sont ouverts en direction du bord (8') du porte-substrat et qui permettent l'entrée des bras de préhension (14) de la pince (2).

13. Dispositif selon l'une des revendications précédentes, **caractérisé par** un dispositif de retrait (19) qui coopère avec la plaque de chargement (3) et qui comporte des supports verticaux (20) qui sont associés à chaque ouverture (5) et sur lesquels la plaque de chargement (3) peut être placée afin de retirer les substrats (1) de la plaque de chargement (3).

14. Dispositif selon la revendication 13, **caractérisé en ce que** les supports verticaux sont formés chacun par au moins trois tiges verticales (20).

15. Dispositif selon l'une des revendications précédentes, **caractérisé en ce qu'**un ou plusieurs robots sont associés au dispositif.

16. Dispositif selon l'une des revendications précédentes, **caractérisé en ce que** plusieurs chambres de réaction sont associées au dispositif, les substrats posés sur la plaque de chargement (3) pouvant être transférés d'une chambre de réaction dans l'autre.

17. Dispositif selon l'une des revendications précédentes, **caractérisé en ce que** le dispositif comporte des appareils d'analyse, tels qu'un appareil infrarouge à transformée de Fourier ou un appareil d'ellipsométrie.

18. Dispositif selon l'une des revendications précédentes, **caractérisé par** une ou plusieurs stations de refroidissement et/ou de chauffage.

19. Dispositif selon l'une des revendications précédentes, **caractérisé par** une station d'orientation permettant d'orienter la plaque de chargement (3).

20. Dispositif selon l'une des revendications précédentes, **caractérisé en ce que** le porte-substrat (7) comporte des rainures de contrôle de rotation pour déterminer la vitesse de rotation et la position en rotation du porte-substrat.

21. Utilisation d'un dispositif selon l'une des revendications précédentes dans un processus de fabrication permettant de déposer des couches de semi-conducteurs sur des substrats semi-conducteurs.

22. Utilisation d'un dispositif selon l'une des revendications précédentes, **caractérisée en ce que** le dispositif est utilisé pour fabriquer un écran de visualisation.

23. Utilisation d'un dispositif selon l'une des revendications précédentes, **caractérisé en ce que** le dispositif est utilisé d'une façon très générale dans un procédé CVD ou bien dans un procédé de revêtement par condensation et notamment pour déposer des couches de semi-conducteurs choisis parmi les éléments du groupe IV, III-V, II-VI, les métaux, les isolants, notamment les diélectriques ainsi que les matières organiques sur des substrats de silicium, des substrats III-V, des substrats II-VI ou des isolants, tels que du verre ou une matière plastique.

24. Utilisation d'un dispositif selon l'une des revendications précédentes, **caractérisée en ce que** le dispositif fonctionne à l'hydrogène et/ou à l'azote.

25. Utilisation d'un dispositif selon l'une des revendications précédentes, **caractérisée par** une procédure de nettoyage automatique intégrée permettant de nettoyer la plaque de chargement (3) dans le dispositif.
